Europäisches Patentamt

**European Patent Office**

Office européen des brevets

(11) Publication number: **0 057 268**
**A2**

# EUROPEAN PATENT APPLICATION

(21) Application number: **81109153.7**

(22) Date of filing: **29.10.81**

(51) Int. Cl.³: **G 03 F 1/00**

(30) Priority: **02.02.81 US 230935**

(43) Date of publication of application: **11.08.82**
**Bulletin 82/32**

(84) Designated Contracting States: **DE FR GB IT**

(71) Applicant: **International Business Machines Corporation, Armonk, N.Y. 10504 (US)**

(72) Inventor: **Hofer, Donald Clifford, 540 LaCrosse Street, Morgan Hill California 95037 (US)**

(74) Representative: **Hobbs, Francis John, IBM United Kingdom Patent Operations Hursley Park, Winchester Hants, SO21 2JN (GB)**

(54) **Method of fabricating X-ray lithographic masks.**

(57) A method is disclosed for fabricating an improved x-ray mask which has a high aspect ratio and vertical side walls. First, a thin electrically conductive film (12) is deposited on top of an x-ray mask substrate (10). The conductive film will later act as an electroplating base but it is also sufficiently thin to be substantially x-ray transparent. A resist pattern (18) is then formed on top of the electroplating base film using an electron beam to expose the resist. The electron beam resist patternwise masks the electroplating base film during subsequent electroplating deposition of an x-ray absorbing layer (20) to form a first x-ray absorbing pattern. An x-ray sensitive resist (40) is then deposited on top of the first x-ray absorbing pattern and exposed to x-rays from the bottom. The first x-ray absorbing pattern thus patternwise shields the x-ray resist. The patternwise exposed x-ray resist is then developed to form an x-ray resist pattern (46). Finally, another layer (48) of x-ray absorbing material is deposited through the x-ray resist pattern by electroplating to form a second x-ray absorbing pattern. In the preferred embodiment, the x-ray resist is positive acting and the first and second x-ray absorbing patterns are complementary. After the second x-ray absorbing pattern is deposited in this embodiment, the first x-ray absorbing pattern is removed.

1

## METHOD OF FABRICATING X-RAY LITHOGRAPHIC MASKS

This invention relates to methods of fabricating x-ray lithographic masks.

A commonly used method for reproducing a pattern is to patternwise expose a photosensitive surface (such as a photoresist layer) to light through a contacting or closely spaced pattern mask. Then the surface is contacted with a developer which preferentially reacts with (for example dissolves) either the exposed regions of the surface or the unexposed regions to reproduce the pattern either as a positive or a negative of the mask pattern. This method has been used extensively in the manufacture of microminiature circuits and circuit components.

The above-described technique is inexpensive and works well so long as the minimum dimension of a structure to be reproduced is not too small in comparison with the wavelength of the exposing light or the resolving capability of the photosensitive surface. Diffraction effects always occur and usually become objectionable with visible light when the minimum dimension of a structure to be reproduced (minimum linewidth) is less than 2 $\mu$m. Since diffraction effects are proportional to the wavelength of the exposing radiation, there has been a tendency to ever reduce the wavelength of the exposing radiation. Ultraviolet light is now used in lithography where minimum linewidth is less than 2 $\mu$m and can be used effectively down to a minimum linewidth of about 0.5 $\mu$m. Electron beam lithography can be used at even much lower linewidths, but has some significant drawbacks, one of which is high cost. Contact printing cannot readily be done with electron beam radiation and the aspect ratio (ratio of thickness to minimum linewidth) of resist layers exposed by electron beam is limited by scattering effects.

The limits of photolithography have also been extended by a further reduction of light wavelength into the x-ray region. U.S. Patent 3,743,842 generally describes this technique.

A mask for x-ray lithography consists of a substrate which transmits x-rays as well as possible and a pattern on the substrate which absorbs x-rays as well as possible. No materials are known which are completely transmissive to x-rays. Therefore, the substrate is made as thin as possible and is fabricated from one or more materials which have suitably low x-ray absorption characteristics.

Likewise, there are no known materials which completely absorb x-rays unless the material has sufficient thickness. The degree of difficulty in fabricating fine patterns with small minimum linewidth increases with the thickness of the layer in which the pattern is to be defined. Accordingly, an x-ray absorbing layer is fabricated from one or more materials which absorb x-rays reasonably well, so that the layer can be made as thin as possible.

The x-ray absorbing pattern obviously must be sufficiently thick so that the ratio between the intensity of x-rays passing through the theoretically non-absorbing regions of the mask and the intensity of x-rays passing through the absorbing regions is suitably high. This ratio is called the contrast of the mask and it effectively limits the minimum thickness of the x-ray absorbing layer. Any reduction in the thickness of the absorbing layer results in passing more x-rays through the absorbing pattern. Therefore, no matter how fine the pattern, any reduction in the thickness of the absorbing layer reduces contrast.

High contrast is very important for an x-ray lithographic mask because sufficient overall contrast must be maintained through an entire lithograph process and contrast can be lost in many other steps of the process. The need for a suitably high contrast x-ray resist with high sensitivity still exists.

0057268

3

As a result of having a constraint on the thickness of the absorbing layer, as the minimum linewidth for an x-ray mask goes down, the aspect ratio (thickness divided by minimum linewidth) of the mask goes up. Patterned layers with high aspect ratios are difficult to fabricate because side walls tend to become non-vertical (or contain a top or bottom inward or outward flange or flare). If the side walls are not completely vertical, the thickness of the absorbing pattern varies gradually at the pattern edges, which results in a gradual rather than sudden variation in the absorption of x-rays near the pattern edges. This effectively blurs pattern edges and effectively reduces the advantage of having high contrast.

The invention seeks to provide a method of fabricating an x-ray mask which has a high aspect ratio with vertical side walls, and so has high contrast at smaller minimum linewidth than has been possible heretofore.

A method of fabricating an x-ray lithographic mask, comprising the successive steps of: depositing an x-ray transparent electroplating base film on an x-ray mask substrate; depositing an electron beam sensitive resist layer over the electroplating base film; patternwise exposing the electron beam resist layer to an electron beam; developing the exposed electron beam resist layer to form an electron beam resist pattern; electroplating a layer of x-ray absorbing material through the electron beam resist pattern onto the electroplating base film to form an x-ray absorbing pattern: characterised, according to the invention, by the further steps of: depositing an x-ray sensitive resist layer over the x-ray absorbing pattern; exposing the bottom side of the substrate to x-rays in order to patternwise expose the deposited x-ray resist layer through the x-ray absorbing pattern; developing the exposed x-ray resist layer to form an x-ray resist pattern; and electroplating a second layer of x-ray absorbing material through the x-ray resist pattern to form a second x-ray absorbing pattern.

4

In the preferred embodiment, the x-ray resist is positive acting and the first and second x-ray absorbing patterns are complementary. After the second x-ray absorbing pattern is deposited in this embodiment, the first x-ray absorbing pattern is removed.

It has been found that when an x-ray sensitive resist, such as poly methyl methacrylate (PMMA), is patternwise exposed to x-rays and the x-ray resist lies on top of an electroplating base film, such as gold, the side wall of the developed resist is not vertical in the vicinity of the base film. Instead, the side wall profile has an undercut at the base film so that a subsequently electroplated x-ray absorbing pattern has a skirt or flange next to the base film. This skirt effectively blurs pattern edges. We believe that the skirt results because photo-electrons are produced during x-ray exposure and scatter into resist regions adjacent to the x-ray exposed regions. Marginal adhesion between the x-ray resist and the plating base then cooperates with this partial exposure to produce an undercut close to the base film and resist interface.

Our mask fabrication method avoids the skirt profile by exposing the x-ray resist instead from the backside through the plating base film and through an x-ray absorbing pattern lying between the x-ray resist and the base film. Since there are now no x-ray resist regions which both are unexposed to x-rays and are in contact with the plating base film, no undercut occurs. The x-ray absorbing pattern used to patternwise expose the x-ray resist is itself formed by electroplating through an electron beam resist pattern. No skirts form in the electron beam resist pattern because it is exposed by electron beam. No penumbra or runout errors occur because the x-ray absorbing pattern used to expose the x-ray resist is in contact with the x-ray resist. The thickness of each of the two x-ray absorbing patterns is uniform and can be well controlled because both are deposited by electroplating.

5

Since thick electron beam resist patterns cannot be made with vertical side walls, our method allows the thickness of the electron beam resist to be less than the thickness of the desired final x-ray absorbing pattern. A comparatively thin layer of electron beam resist is used to form a first x-ray absorbing pattern which consequently also is thinner than desired for the absorbing pattern of the final x-ray mask. The first x-ray absorbing pattern is then used to expose a layer of x-ray resist which in turn is used to form a second x-ray absorbing pattern. The second x-ray absorbing pattern, either alone or in combination with the first x-ray absorbing pattern, has the desired thickness and aspect ratio.

How the invention can be carried out will now be described by way of example, with reference to the accompanying drawings, in which:

FIGS. 1.1 - 1.7 illustrate step-by-step in cross-section the prior art x-ray mask fabrication method which results in a non-vertical side wall profile;

FIGS. 2.1 - 2.7 illustrate step-by-step in cross-section a preferred method according to the invention, for fabricating an x-ray mask with vertical side walls;

FIGS. 3.1 - 3.3 illustrate step-by-step in cross-section a modified method according to the invention, using negative acting x-ray resist; and

FIG. 4 is a block diagram of the method steps carried out in accordance with this invention.

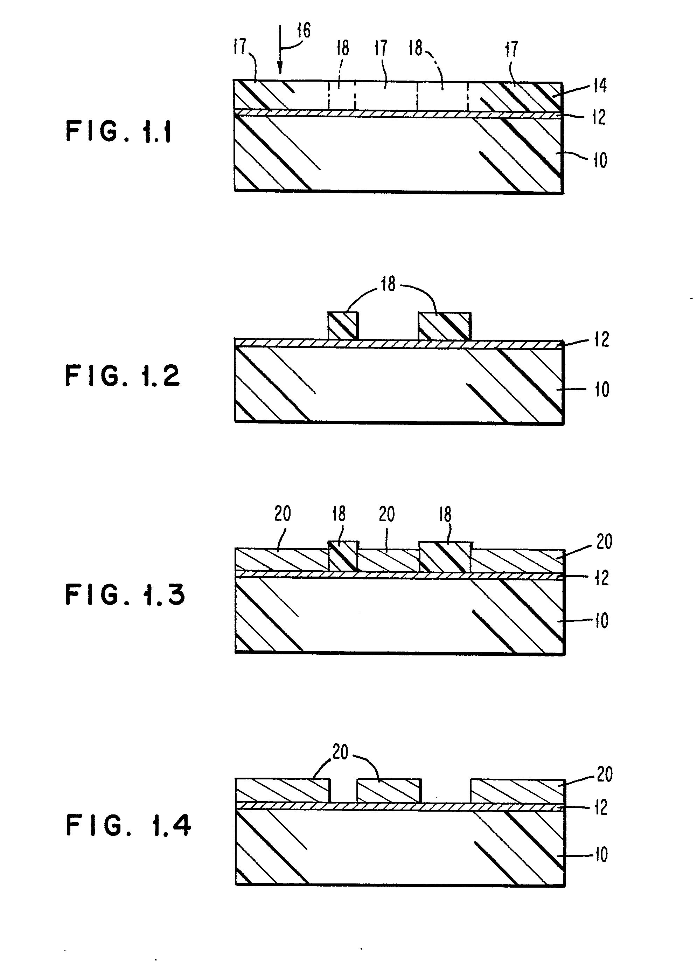

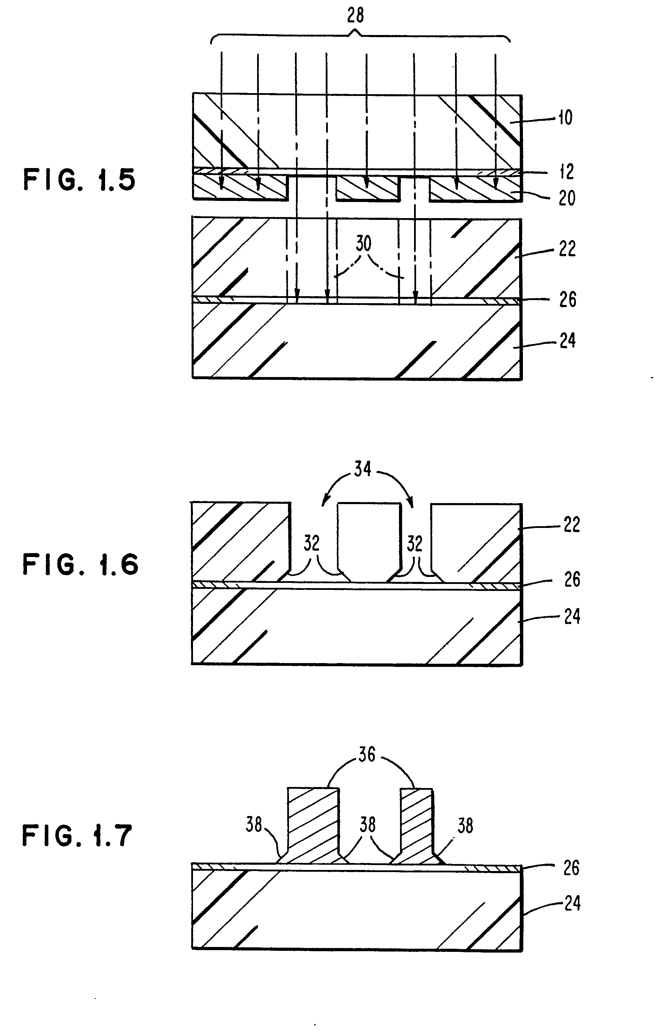

FIGS. 1.1 - 1.7 illustrate a typical prior art method for fabricating an x-ray mask. A substrate 10 is coated with a thin x-ray transparent electroplating base film 12, such as gold, and covered with a resist layer 14 which is electron beam sensitive, such as poly methyl methacrylate (PMMA). An electron beam 16 exposes layer 14 to a desired pattern of electron beam radiation. In FIG. 1.1, for example, regions 17 are exposed to the electron beam. Resist layer 14 is normally positive acting because positive electron beam resists which are available have much better contrast than available negative electron beam resists. If resist layer 14 is positive acting, the average molecular weight is reduced in regions 17 due to the exposure to an electron beam, and regions 17 preferentially dissolve during subsequent development leaving regions 18 (FIG. 1.2). If a negative acting electron beam resist is used instead, the same pattern shown in FIG. 1.2 would still result if an electron beam exposure pattern is used which is the negative or complement of the pattern used with positive acting resist (i.e., regions 18 would be exposed).

A patterned layer 20 of x-ray absorbing material, such as gold, is then electroplated through the resulting resist pattern 18 to a depth not greater than the thickness of the resist pattern 18 (FIG. 1.3).

Resist pattern 18 is then optionally removed (FIG. 1.4). The purpose in removing this resist is to avoid absorbing x-rays in the resist material during the next step. Obviously, if the electron beam resist is sufficiently transparent to x-rays, it need not be removed. Patterned layer 20 actually is a low aspect ratio x-ray mask. The thickness of the x-ray mask is limited by the thickness of the electron beam resist 18, which in turn has a thickness limited by electron beam scattering. If resist layer 14 is increased too much in thickness, electron scattering results in an undercut side wall profile for the resist pattern 18. The increase in development time necessary to develop through a thicker resist layer also may widen the holes or lines of the resist pattern, thereby effectively also increasing the minimum linewidth.

Aspect ratio is increased in the prior art method by using the low aspect ratio x-ray mask to form a separate high aspect ratio x-ray mask using x-ray lithography (FIG .1.5). Mask 20 is inverted and placed in close proximity to (or in contact with) an x-ray sensitive resist layer 22, such as PMMA, of suitably high thickness lying on top of another substrate 24. Substrate 24 has also been coated with a plating base film 26, such as gold. Resist layer 22 is then exposed to x-rays 28 through mask 20. Regions 30 in resist layer 22 become exposed to x-rays. When resist layer 22 is developed, however, undercuts 32 appear in the side wall profile (FIG. 1.6) of holes 34. X-ray absorbing material 36, such as gold, is finally plated into holes 34 and the resist pattern is removed (FIG. 1.7). If the resist layer 22 does not absorb x-rays very well, which is usually true with x-ray resists, it need not be removed. Since the resist pattern has side wall undercuts 32, the plated x-ray absorbing pattern 36 has side wall skirts 38. The undercuts are believed to be caused by x-ray generation of photo-electrons which scatter across to resist regions not directly exposed by x-rays. Normally there is also marginal adhesion between an x-ray sensitive resist and a plating base film, which it is believed also contributes to formation of these undercuts.

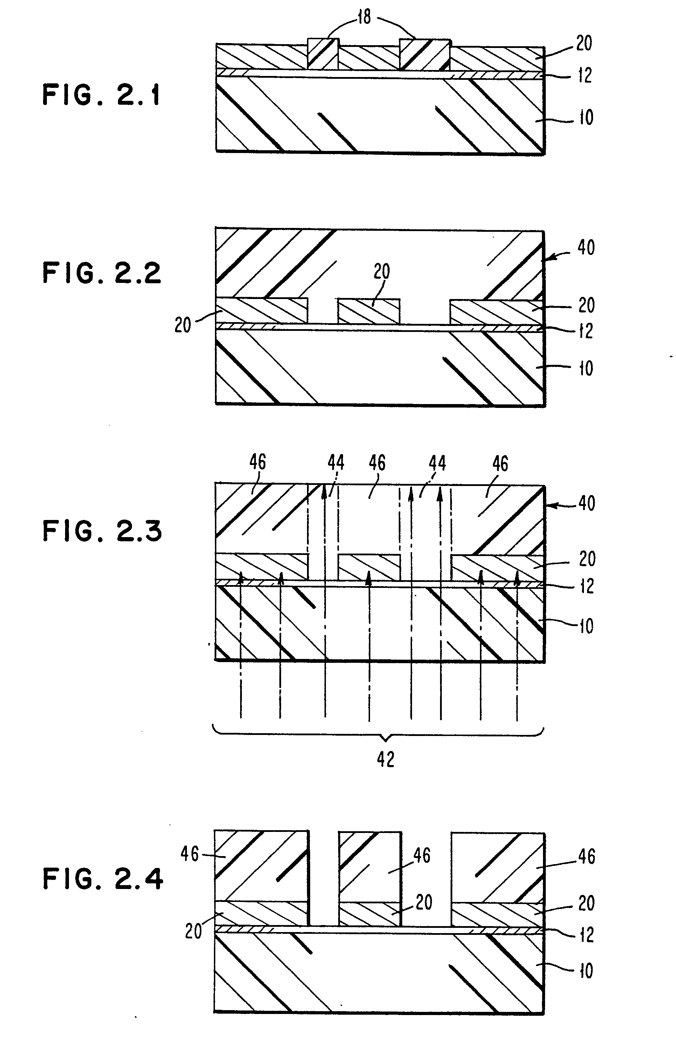

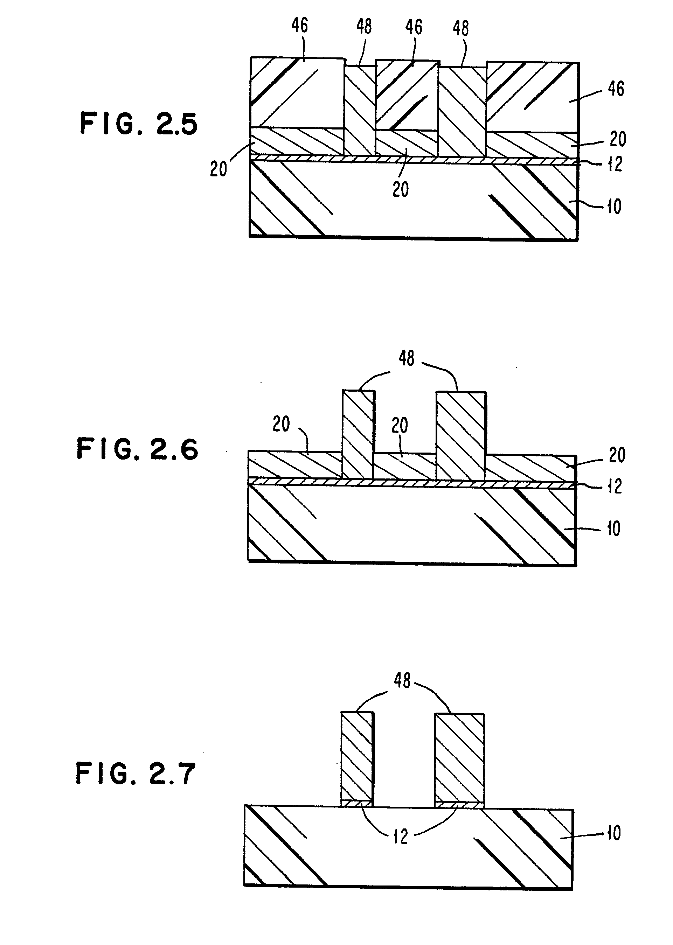

FIGS. 2.1 - 2.7 illustrate a preferred method of fabricating an improved x-ray mask. Only one substrate is used in this method. The substrate which carries the electron beam resist pattern will later carry the final x-ray absorbing pattern and will be the substrate for the final x-ray mask.

As previously mentioned, the substrate for an x-ray mask should be as thin as possible, in order to be as transparent to x-rays as possible. However, thin substrates are very fragile. Therefore, an x-ray absorbing pattern is normally fabricated on a thick substrate and the substrate is thinned after the absorbing pattern is formed. Thinning of the substrate is usually done by an etching process but

8

other methods can be used.  The preferred method according to the
invention, also contemplates that the x-ray mask substrate will be
relatively thick during the processing steps which result in formation
of the final x-ray absorbing pattern and that the substrate will
then be thinned to the final desired thickness.  For purposes of
illustration however, only one substrate thickness is described and
shown. It should be understood that the illustrated substrate may
either represent a substrate which has already been thinned or a
substrate which will be thinned at some point during or following
the method being described.

X-ray mask substrates normally are composite laminated structures.
Any known x-ray mask substrate may be used with our method, such as
silicon, polyimide, boron nitride, or silicon carbide, so long as an
electroplating base film will adhere or can be made to adhere to the
substrate.  We prefer to use a composite structure in which about a
2 μm thick polyimide layer is deposited on top of a silicon substrate
which has been boron doped near the interface.  At some point prior
to the step of x-ray exposing the bottom side of the substrate, the
undoped silicon is selectively etched away leaving a thin composite
structure of polyimide and boron doped silicon.  The silicon gives
the x-ray mask substrate dimensional stability while the polyimide
provides strength for the substrate.

Our method begins with steps similar to  the above-described
prior art method.   FIG. 2.1 shows the same structure as FIG. 1.3,
with identical reference numerals.  It is fabricated in the same
fashion as described in connection with FIGS. 1.1 - 1.3 by depositing
an electron beam resist layer on an x-ray mask substrate coated with
an electroplating base film, patternwise exposing the resist to an
electron beam, developing the resist, and electroplating x-ray
absorbing material, such as nickel or gold, onto the plating base film to form an x-ray absorbing pattern. The plating base film preferably comprises gold with a thickness between about 100 and 700 angstroms, preferably about 200-300 angstroms. If nickel is used as a plating base, the nickel film thickness should be between about 400 and 700 angstroms. Gold is preferred for the plating base film because in our preferred embodiment two different x-ray absorbing materials are electroplated onto the same base film. Both gold and nickel may be electroplated well onto a gold base film. Since gold does not adhere too well to polyimide (the top layer of our preferred x-ray substrate composite), we furthermore prefer to deposit a chrome film between the polyimide layer and the gold film. A chrome film of between about 50 and 100 angstroms, preferably about 75 angstroms, for example, greatly improves the gold film adhesion. The preferred electroplating base film thus preferably is a composite laminated structure having a thickness within the range of about 100 to 800 angstroms. Alloys could also be used.

The electron beam resist pattern 18 may or may not be removed at this point. If the electron beam resist material is sufficiently transparent to x-rays, and the presence of this material does not create processing problems later, it can remain. We prefer to remove the electron beam resist. The structure would look like FIG. 1.4 at this stage.

The first x-ray absorbing pattern 20 is now covered with an x-ray resist layer 40 (FIG. 2.2). The total thickness of this resist layer measured from the plating base film 12 should be sufficient such that after developing the x-ray resist, it has a thickness slightly greater than the desired thickness of the final x-ray absorbing pattern. Any x-ray resist may be used, either positive acting or negative acting. However, later processing steps will vary depending upon this selection. Also, when a negative x-ray resist is used, the final x-ray absorbing pattern will be the complement or negative of the pattern obtained when a positive x-ray resist is used. We prefer to use a positive x-ray resist, such as PMMA, because positive x-ray resists are available with better contrast than negative x-ray resists.

The bottom surface of substrate 10 is now flooded with x-rays 42 (FIG. 2.3). Alternatively, the bottom surface of substrate 10 could be scanned with an x-ray beam. X-ray absorbing pattern 20 patternwise shields the x-ray resist 40 from x-rays passing through the substrate 10 and film 12 so that only regions 44 become exposed.

The patternwise exposed x-ray resist is then developed using a suitable solvent, such as methyl isobutyl ketone and isopropyl alcohol for PMMA. The exposed regions 44 of a positive resist develop away to leave an x-ray resist pattern 46 as shown in FIG. 2.4. It should be noted that if the electron beam resist was not removed earlier, it would be removed with a suitable solvent at this point (assuming use of a positive x-ray resist). If both resists are PMMA, any remaining electron beam resist would be removed automatically during the x-ray resist development step.

X-ray absorbing material, such as gold, is now electroplated onto the plating base film 12 to form a second x-ray absorbing pattern 48 (FIG. 2.5). Since positive x-ray resist was used, this second x-ray absorbing pattern is the complement or negative of the first x-ray absorbing pattern 20, and of course it is much thicker.

Finally, in the case where a positive x-ray resist was used, the first x-ray absorbing pattern 20 must be removed. In order to do this, the x-ray resist pattern 46 is first removed (FIG. 2.6) and then the x-ray absorbing pattern 20 is removed (FIG. 2.7). If the x-ray resist pattern 46 is PMMA, for example, it would first be exposed to actinic radiation, such as x-rays or ultraviolet light, and then would be dissolved in a developer such as methyl isobutyl ketone in isopropyl alcohol. In order to selectively remove the first x-ray absorbing pattern 20 and leave the second x-ray absorbing pattern 48, the first and second x-ray absorbing materials must have a different composition. Preferably the first x-ray absorbing material comprises nickel and the second x-ray absorbing material comprises gold. An aqueous solution of ferric chloride, for example, then dissolves the nickel, but not the gold. The plating base film optionally may also be removed in regions under the first x-ray absorbing pattern, as shown in FIG. 2.7. This automatically happens if the composition of the plating base film is the same as the composition of the first x-ray absorbing pattern. A gold film may be removed, for example, by argon ion milling. The plating base film must be removed if it interferes with a subsequent step such as optical alignment for example.

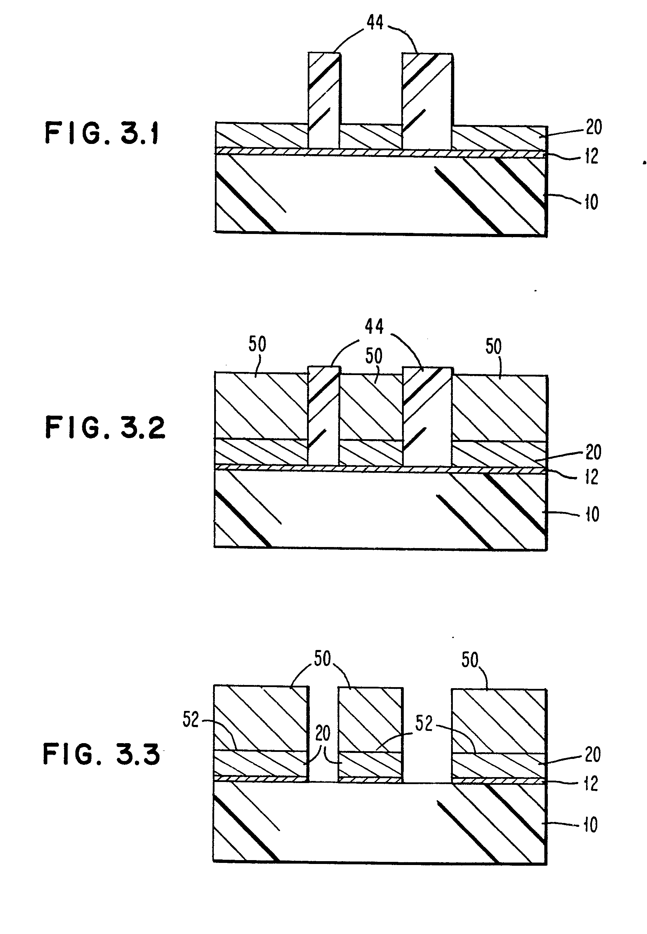

FIGS. 3.1 - 3.3 illustrate our method using an x-ray resist 40 which is negative acting. In this case the x-ray exposed regions 44 remain after development and the unexposed regions 46 develop away as shown in FIG. 3.1.

X-ray absorbing material is again electroplated onto the structure at this point, but the material 50 deposits on the first x-ray absorbing pattern 20 rather than on the plating base film 12 (FIG. 3.2).

No further steps are necessary if the x-ray resist pattern 44 is sufficiently transparent to x-rays. Otherwise, x-ray resist pattern 44 must be removed using a suitable solvent. The portions of the plating base film which are under the resist pattern optionally also may be removed. Both the resist pattern 44 and the underlying plating film have been removed in FIG. 3.3.

It is preferable, but not essential, that the second x-ray absorbing pattern 50 in this embodiment and the first x-ray absorbing pattern 20 both have the same composition. If they do have the same composition, the first and second x-ray absorbing patterns together form a single homogeneous final x-ray absorbing pattern.  Otherwise, the final x-ray absorbing pattern has different upper and lower compositions with an interface 52 therebetween.

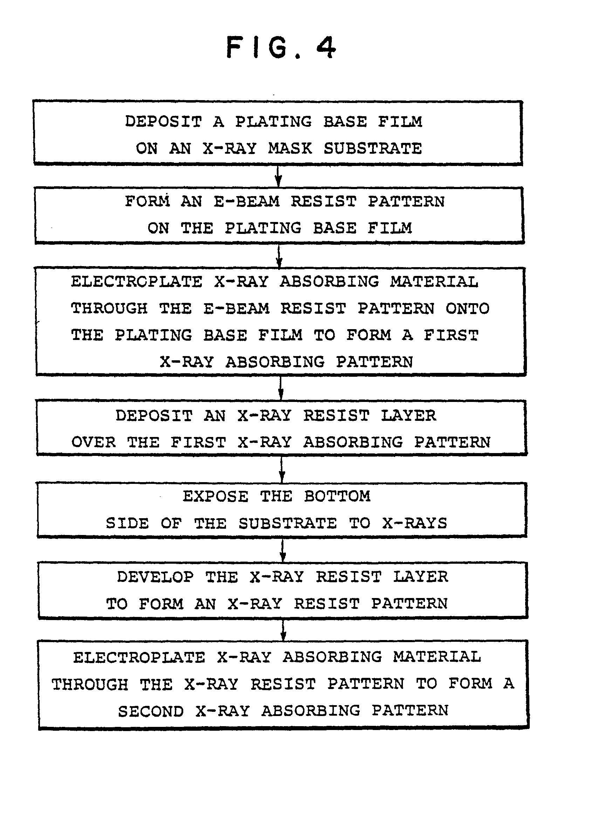

FIG. 4 sets forth the general steps of our method.  Variations in the particular steps taken in carrying out our method will be apparent to those skilled in lithography.

CLAIMS

1.    A method of fabricating an x-ray lithographic mask, comprising the successive steps of:

depositing an x-ray transparent electroplating base film (12) on an x-ray mask substrate (10);

depositing an electron beam sensitive resist layer (14) over the electroplating base film;

patternwise exposing the electron beam resist layer to an electron beam;

developing the exposed electron beam resist layer to form an electron beam resist pattern (18);

electroplating a layer of x-ray absorbing material (20) through the electron beam resist pattern onto the electroplating base film to form an x-ray absorbing pattern;

the method being characterised by the further steps of:

depositing an x-ray sensitive resist layer (40) over the x-ray absorbing pattern;

exposing the bottom side of the substrate to x-rays in order to patternwise expose the deposited x-ray resist layer through the x-ray absorbing pattern;

developing the exposed x-ray resist layer to form an x-ray resist pattern (46);   and

electroplating a second layer (48) of x-ray absorbing material through the x-ray resist pattern to form a second x-ray absorbing pattern.

14

2.     A method as claimed in claim 1, further comprising the step of removing the electron beam resist pattern prior to deposition of the x-ray sensitive resist layer.

3.     A method as claimed in claim 1, wherein the x-ray sensitive resist is positive acting, the method further comprising the steps of:

removing the electron beam resist pattern prior to electroplating the second x-ray absorbing pattern, the second x-ray absorbing pattern being electroplated onto the electroplating base film;  and

removing the first x-ray absorbing pattern after electroplating the second x-ray absorbing pattern.

4.     A method as claimed in claim 3, wherein the electron beam resist pattern is removed prior to deposition of the x-ray sensitive resist layer.

5.     A method as claimed in claim 3 or claim 4, wherein the electroplating base film comprises nickel and has a thickness between 400 and 700 angstoms.

6.     A method as claimed in claim 3 or claim 4, wherein the electroplating base film comprises gold and has a thickness between 100 and 800 angstoms.

7.     A method as claimed in any of claims 3 to 6, wherein the first x-ray absorbing pattern comprises nickel and the second x-ray absorbing pattern comprises gold.

8.     A method as claimed in claim 1, wherein the x-ray sensitive resist is negative acting, and wherein the second x-ray absorbing pattern is electroplated onto the first x-ray absorbing pattern.

9.    A method as claimed in claim 8, wherein the electroplating base film comprises gold, the first x-ray absorbing pattern comprises gold, and the second x-ray absorbing pattern comprises gold.

10.    A method as claimed in claim 8 or claim 9, further comprising the steps of:

removing the x-ray resist pattern;   and

removing the electron beam resist pattern.

0057268

**FIG. 1.1**

**FIG. 1.2**

**FIG. 1.3**

**FIG. 1.4**

0057268

**FIG. 1.5**

**FIG. 1.6**

**FIG. 1.7**

0057268

FIG. 2.1

18
20
12
10

FIG. 2.2

40
20
20
12
10

FIG. 2.3

46    44    46    44    46
40
20
12
10
42

FIG. 2.4

46
46
46
20
20
12
20
10

**FIG. 2.5**

**FIG. 2.6**

**FIG. 2.7**

**FIG. 3.1**

**FIG. 3.2**

**FIG. 3.3**

# FIG. 4

```
┌─────────────────────────────────────────────┐
│        DEPOSIT A PLATING BASE FILM            │
│        ON AN X-RAY MASK SUBSTRATE             │
└─────────────────────────────────────────────┘
                      │
                      ▼
┌─────────────────────────────────────────────┐
│        FORM AN E-BEAM RESIST PATTERN          │
│         ON THE PLATING BASE FILM              │
└─────────────────────────────────────────────┘
                      │
                      ▼
┌─────────────────────────────────────────────┐
│   ELECTROPLATE X-RAY ABSORBING MATERIAL       │
│   THROUGH THE E-BEAM RESIST PATTERN ONTO      │
│   THE PLATING BASE FILM TO FORM A FIRST       │
│         X-RAY ABSORBING PATTERN               │
└─────────────────────────────────────────────┘
                      │
                      ▼
┌─────────────────────────────────────────────┐
│        DEPOSIT AN X-RAY RESIST LAYER          │
│   OVER THE FIRST X-RAY ABSORBING PATTERN      │
└─────────────────────────────────────────────┘
                      │
                      ▼
┌─────────────────────────────────────────────┐
│             EXPOSE THE BOTTOM                 │
│      SIDE OF THE SUBSTRATE TO X-RAYS          │
└─────────────────────────────────────────────┘
                      │
                      ▼
┌─────────────────────────────────────────────┐
│        DEVELOP THE X-RAY RESIST LAYER         │
│       TO FORM AN X-RAY RESIST PATTERN         │
└─────────────────────────────────────────────┘
                      │
                      ▼
┌─────────────────────────────────────────────┐
│   ELECTROPLATE X-RAY ABSORBING MATERIAL       │
│  THROUGH THE X-RAY RESIST PATTERN TO FORM A   │
│      SECOND X-RAY ABSORBING PATTERN           │
└─────────────────────────────────────────────┘
```